# EUROPÄISCHE PATENTSCHRIFT

(11) **EP 1 794 854 B1**
(45) Veröffentlichungstag und Bekanntmachung des Hinweises auf die Patenterteilung: **29.12.2010**
(21) Anmeldenummer: 05794743.4
(22) Anmeldetag: 21.09.2005
(51) Int. Cl.: H01S 5/026, H01S 5/183, G01S 15/58

(54) **OPTISCHES SENSORMODUL**
OPTICAL SENSOR MODULE
MODULE DE DETECTION OPTIQUE

(30) Priorität: 30.09.2004 DE 102004047679
(43) Veröffentlichungstag der Anmeldung: 13.06.2007
(73) Patentinhaber: OSRAM Opto Semiconductors GmbH, 93055 Regensburg (DE)
(72) Erfinder: ALBRECHT, Tony, 93077 Bad Abbach (DE); BRICK, Peter, 93051 Regensburg (DE); PHILIPPENS, Marc, 93049 Regensburg (DE); STEEGMÜLLER, Ulrich, 93055 Regensburg (DE)
(74) Vertreter: Epping - Hermann - Fischer
(86) Internationale Anmeldenummer: PCT/DE2005/001667
(87) Internationale Veröffentlichungsnummer: WO 2006/034677

(56) Entgegenhaltungen:
- EP-A- 0 709 940
- WO-A-02/093694
- WO-A-2004/068166
- US-A- 5 648 979
- US-A- 5 748 661
- US-A- 6 111 903
- US-A1- 2002 104 957
- PATENT ABSTRACTS OF JAPAN Bd. 2000, Nr. 07, 29. September 2000 (2000-09-29) -& JP 2000 106471 A (NIPPON TELEGR & TELEPH CORP <NTT>), 11. April 2000 (2000-04-11)
- PATENT ABSTRACTS OF JAPAN Bd. 1996, Nr. 11, 29. November 1996 (1996-11-29) -& JP 08 186327 A (SONY CORP), 16. Juli 1996 (1996-07-16)

## Beschreibung

Die Erfindung betrifft ein optisches Sensormodul nach dem Oberbegriff des Anspruchs 1 sowie ein Verfahren zur Messung der Relativbewegung eines Objekts gegenüber einem optischen Sensormodul.

Optische Sensormodule der genannten Art werden z.B. zur berührungslosen Messung von Bewegungen eingesetzt. Sie sind typischerweise als kompakte Einheit aus einer Lichtquelle und einem Detektor ausgeführt und werden daher auch als optische Sender-Empfänger-Module bezeichnet.

Eine Reihe von Methoden zur berührungslosen optischen Bestimmung der Bewegung eines Objekts beruht darauf, das Objekt mit kohärentem Licht zu beleuchten und aus der Phasenänderung des von dem Objekt zurückgestreuten Lichts die Bewegung des Objekts zu bestimmen. Üblicherweise wird die Phasenänderung des zurückgestreuten Lichts durch interferometrische Methoden gemessen.

Ein bekannter Weg zur Bestimmung dieser Phasenänderung ist, das Licht einer kohärenten Lichtquelle in zwei Teilstrahlen aufzuteilen, mit einem der beiden Teilstrahlen das Objekt zu beleuchten (Messstrahl), den anderen Teilstrahl (Referenzstrahl) mit dem vom Objekt zurückgestreuten Licht zu überlagern und auf einen Detektor zu leiten. Durch den Strahlteiler wird erreicht, dass Mess- und Referenzstrahl zueinander phasenkorreliert sind. Eine Phasenänderung des rückgestreuten Lichts führt bei der Überlagerung zu einer Intensitätsmodulation und entsprechend zu einer Modulation des Detektorsignals. Nachteilig an einem solchen, in seinem Grundprinzip an ein Michelson-Interferometer angelehnten Aufbau zur Bewegungsmessung ist, dass mit dem Strahlteiler ein zusätzliches optisches Element eingesetzt werden muss. Neben dem dadurch komplexeren Aufbau bedingt der Einsatz eines Strahlteilers üblicherweise eine aufwändigere Justage der einzelnen Komponenten zueinander.

Als eine weitere Methode zur Bestimmung der Phasenänderung ist bekannt, einen Laser als kohärente Lichtquelle mit großer Kohärenzlänge zur Beleuchtung des Objekts einzusetzen und einen Teil des von dem Objekt zurückgestreuten Lichts in den Resonator des Lasers zurückzuführen. Bei dieser Methode wird das mit dem beleuchtenden Strahl in einer festen Phasenbeziehung stehende Strahlungsfeld im Resonator als Phasenreferenz genutzt. Die Interferenz des rückgestreuten Lichts mit dem Strahlungsfeld im Resonator führt zu einer Modulation der Intensität des Strahlungsfeldes (Selbstmischungseffekt) und somit auch der Intensität des von dem Laser abgestrahlten Lichts, die vom einem Detektor bestimmt wird. Ein Vorteil dieser Anordnung ist, dass das zur Beleuchtung eingesetzte Licht und das rückgestreute Licht die selbe optische Achse aufweisen. Eine aufwändige Justage von Komponenten, um zu erreichen, dass sich zurückgestreutes Licht und ein Referenzstrahl geeignet überlagern, entfällt.

Die Anwendung dieses Selbstmischungseffekts wird beispielsweise in M. H. Koelink et al., Applied Optics Vol. 31, No. 18, 1992 pp. 3401-3408 beschrieben. Die Laserstrahlung wird dabei von einem Halbleiterlaser in eine Faser eingekoppelt und auf das Objekt geleitet.

Aus der Druckschrift WO 2004/068166 A1 ist eine Anordnung bekannt, bei der der Selbstmischungseffekt in einem oberflächenemittierenden Halbleiterlaser zur Bestimmung der Bewegung eines Objekts ausgenutzt wird. Wegen der meist kurzen Resonatorlänge eines oberflächenemittierenden Halbleiterlasers ist der Selbstmischungseffekt bei dieser Laserbauform besonders ausgeprägt.

In beiden Fällen wird zur Detektion der Intensität im Strahlungsfeld des Resonators ein Teil des abgestrahlten Laserlichts auf einen Detektor gelenkt. Das wird entweder durch einen Strahlteiler, durch ein diffraktives optisches Element oder dadurch erreicht, dass der Detektor auf der dem Objekt gegenüberliegenden Seite des Lasers auf dessen optischer Achse angeordnet ist und ein Teil der Strahlung im Resonator direkt auf den Detektor ausgekoppelt wird.

Unvorteilhaft ist, dass der Detektor damit nicht gegenüber Umgebungslicht, das in Richtung des Resonators in diesen eindringt, abgeschirmt ist. Weiterhin treten, insbesondere bei großer Oberflächenrauhigkeit des bewegten Objekts als sogenannte Speckle-Reflexe bekannte laterale Intensitätsschwankung innerhalb des Resonators auf. Diese Speckle-Reflexe ändern zwar prinzipiell die Gesamtintensität der Strahlung im Resonator nicht, haben aber aufgrund einer meist nicht über die gesamte Querschnittsfläche des Resonators homogenen Detektorempfindlichkeit dennoch einen Einfluss auf die detektierte Intensität. Weiterhin sind beide Anordnungen nicht gut geeignet, um Laser und Detektor zu einem kompakten optischen Sensormodul zusammenzufügen, da die Position von Laser und Detektor zueinander für eine Integration beider Komponenten innerhalb eines Halbleiterkörpers oder auf ein gemeinsames Substrat ungünstig ist.

In der Druckschrift US 5,748,661 A ist ein integrierter, lateraler Detektor, ein Laserbauteil sowie eine Herstellungsmethode hierfür angegeben.

Die Druckschrift US 2002/0104957 A1 betrifft eine Methode zur Messung der Bewegung eines Eingabegeräts.

Ein oberflächenemittierender Laser ist in der Druckschrift JP 2000-106471 A beschrieben.

Die Aufgabe der vorliegenden Erfindung ist daher, ein optisches Sensormodul zu schaffen, bei dem eine Halbleiterlaservorrichtung als Lichtquelle und ein Detektorelement so angeordnet sind, dass die Intensität der Strahlung im Resonator der Halbleiterlaservorrichtung über das Detektorelement bestimmt werden kann, bei dem das Detektorelement möglichst unempfindlich gegenüber in die Halbleiterlaservorrichtung einfallendes Umgebungslicht und gegenüber Speckle-Reflexen ist, und bei dem die Möglichkeit besteht, das optische Sensormodul in einfacher Weise auf ein Substrat integriert aufzubauen. Eine weitere Aufgabe der vorliegenden Erfindung ist, ein Verfahren zu beschreiben, um mit einem derartigen optischen Sensormodul die Bewegung eines Objekts zu bestimmen.

Diese Aufgabe wird gelöst durch ein optisches Sensormodul mit den Merkmalen des Anspruchs 1 sowie durch das in Anspruch 9 beschriebene Verfahren. Vorteilhafte Weiterbildungen und Ausgestaltungen sind in den abhängigen Ansprüchen angegeben.

Erfindungsgemäß ist ein optisches Sensormodul mit einem Halbleiterkörper, der eine Halbleiterlaservorrichtung zur Emission von kohärenter Strahlung mit einem Verstärkerbereich, einem Resonatorspiegel und einem Auskoppelspiegel, sowie ein Detektorelement mit einer strahlungsdetektierenden Zone und einen Wellenleiterbereich mit einem Wellenleiter aufweist, vorgesehen. Das Detektorelement ist über den Wellenleiter mit der Halbleiterlaservorrichtung verbunden, wobei der Wellenleiter in einer Richtung quer zur Hauptstrahlungsrichtung der von der Halbleiterlaservorrichtung emittierten kohärenten Strahlung angeordnet ist.

Dem Detektorelement wird über den Wellenleiter somit Strahlung aus dem Verstärkerbereich zugeführt, die nicht parallel zur Hauptstrahlungsrichtung der Halbleiterlaservorrichtung verläuft, also nicht die Resonator-Bedingung erfüllenden Mode angehört. Den Hauptanteil dieser Strahlung bildet Strahlung aufgrund von spontaner Emission, die auf ihrem Weg durch den Verstärkerbereich durch induzierte Emission verstärkt sein kann (ASE - amplified spontaneous emission). Ein geringerer Teil der Strahlung kann auch durch Streuung von Strahlung einer im Resonator eingefangenen Mode an Defekten des Verstärkerbereichs herrühren. Insgesamt zeichnet sich diese Strahlung dadurch aus, dass sie eine geringere Kohärenz aufweist, als die vom Laser in seiner Hauptstrahlungsrichtung abgestrahlte Strahlung. Sie wird daher im Folgenden zusammenfassend und zur Abgrenzung als teilweise inkohärente Strahlung bezeichnet.

Die detektierte, teilweise inkohärente Strahlung ist ein Maß für die Intensität der Strahlung im Resonator, da die Intensität sowohl der spontan emittierten Strahlung, als auch der abgestrahlten kohärenten Strahlung und der Strahlung im Resonator von der Größe der Besetzungsinversion eines Lasers abhängen. Durch die Anordnung des Wellenleiters quer zur Hauptstrahlungsrichtung ist der Detektor aber vorteilhaft vor einfallendem Umgebungslicht geschützt, da Umgebungslicht wegen der meist hohen Brechungszahl des Verstärkerbereichs nur in einem engen Öffnungskegel um die Hauptstrahlrichtung des Lasers einfallen kann. Laterale Intensitätsvariationen im Resonator, zum Beispiel durch Speckle-Reflexe hervorgerufen, werden durch die seitliche Detektion vorteilhaft über den gesamten ResonatorQuerschnitt gemittelt.

In einer vorteilhaften Ausführungsform des optischen Sensormoduls ist der Wellenleiter senkrecht zur Hauptstrahlungsrichtung der von der Laservorrichtung emittierten kohärenten Strahlung angeordnet.

Die Halbleiterlaservorrichtung des optischen Sensormoduls ist ein oberflächenemittierender Laser.

Gemäß der Erfindung sind die Halbleiterlaservorrichtung, das Detektorelement und der Wellenleiter monolithisch integriert ausgeführt.

Es ist ferner eine gemeinsame epitaktische Schichtstruktur vorhanden, die für die Halbleiterlaservorrichtung den Verstärkerbereich bildet, die für das Detektorelement die strahlungsdetektierende Zone bildet und die den Wellenleiter bildet. Besonders bevorzugt ist, dass die gemeinsame epitaktische Schichtstruktur eine Quantentopfstruktur ist. Die Bezeichnung Quantentopfstruktur umfasst im Rahmen der Anmeldung jegliche Struktur, bei der Ladungsträger durch Einschluss ("confinement") eine Quantisierung ihrer Energiezustände erfahren. Insbesondere beinhaltet die Bezeichnung Quantentopfstruktur keine Angabe über die Dimensionalität der Quantisierung. Sie umfasst somit u.a. Quantentröge, Quantendrähte und Quantenpunkte.

Außerdem weisen die Halbleiterlaservorrichtung, der Wellenleiter und das Detektorelement die gleiche epitaktische Schichtanordnung auf.

In einer bevorzugten Weiterbildung der Erfindung sind der Resonatorspiegel und der Auskoppelspiegel als Bragg-Spiegel ausgeführt. Besonders bevorzugt ist, dass die Reflektivität des Auskoppelspiegels so optimiert ist, dass die vom Detektorelement detektierte Strahlung durch die Bewegung eines von der Halbleiterlaservorrichtung beleuchteten und rückstreuenden Objekts beeinflusst wird.

Bei dem erfindungsgemäßen Verfahren wird das Objekt mit der von der Halbleiterlaservorrichtung emittierten kohärenten Strahlung beleuchtet. Ein Teil der von dem Objekt zurückgestreuten Strahlung wird mit der Strahlung innerhalb der Halbleiterlaservorrichtung derart überlagert, dass die Intensität der von der Halbleiterlaservorrichtung erzeugten teilweise inkohärenten Strahlung von der zurückgestreuten Strahlung abhängig ist. Die Intensität der teilweise inkohärenten Strahlung wird von dem Detektorelement gemessen. Anhand des Signals des Detektors wird die Bewegung des Objekts relativ zur Richtung der von der Halbleiterlaservorrichtung emittierten kohärenten Strahlung bestimmt.

Im Rahmen des erfindungsgemäßen Verfahrens führt die Überlagerung der zurückgestreuten Strahlung mit der Strahlung innerhalb der Halbleiterlaservorrichtung zu einer Änderung der Größe der Besetzungsinversion in der Halbleiterlaservorrichtung und die Änderung der Größe der Besetzungsinversion zu einer Änderung der Intensität der von der Halbleiterlaservorrichtung emittierten, teilweise inkohärenten Strahlung.

In einer bevorzugten Weiterbildung des Verfahrens wird die teilweise inkohärente Strahlung der Halbleiterlaservorrichtung über einen Wellenleiter in das Detektorelement geführt.

Erfindungswesentlich an dem beschriebenen Verfahren ist, dass die Intensität, beziehungsweise die Intensitätsänderung, hervorgerufen durch die Bewegung eines beleuchteten Objekts, der kohärenten Strahlung in einer Halbleiterlaservorrichtung über die von ihr emittierte, teilweise inkohärente Strahlung bestimmt wird.

Die Erfindung wird im Folgenden anhand eines Ausführungsbeispiels unter Zuhilfenahme von drei Figuren näher erläutert.

Es zeigen:
Figur 1 eine schematische Schnittansicht eines Ausführungsbeispiels des erfindungsgemäßen optischen Sensormoduls,
Figur 2 eine schematische Aufsicht auf das in Figur 1 gezeigte Ausführungsbeispiel des erfindungsgemäßen optischen Sensormoduls und
Figur 3 eine schematische Aufsicht auf ein weiteres Ausführungsbeispiel des erfindungsgemäßen optischen Sensormoduls.

Die Figuren sind als schematische Zeichnung zu verstehen. Insbesondere sind die Größenverhältnisse der Elemente nicht maßstabsgerecht dargestellt. Zum besseren Verständnis sind einige Details in den Figuren übertrieben groß dargestellt. Gleiche oder gleich wirkende Elemente sind in den Figuren mit denselben Bezugszeichen versehen.

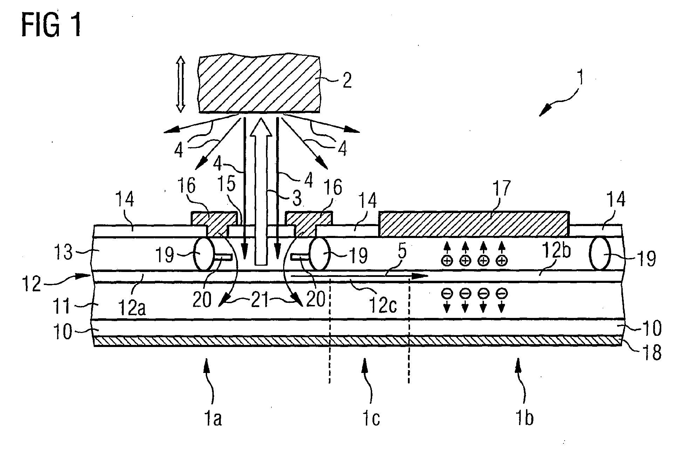

Das in Figur 1 gezeigte optische Sensormodul 1 lässt sich in drei Bereiche untergliedern: eine Halbleiterlaservorrichtung la auf der linken Seite, ein Detektorelement 1b auf der rechten Seite und einen Wellenleiterbereich 1c im mittleren Teil der Anordnung. Der Halbleiterlaservorrichtung 1a gegenüber ist ein bewegtes Objekt 2 angeordnet, welches von der Halbleiterlaservorrichtung 1a mit kohärentem Licht 3 beleuchtet wird. Das von dem Objekt 2 zurückgestreute Licht 4 tritt teilweise zurück in die Halbleiterlaservorrichtung 1a ein. Weiterhin geht von der Halbleiterlaservorrichtung 1a teilweise inkohärentes Licht 5 aus.

Das optische Sensormodul 1 ist monolithisch integriert auf einem gemeinsamen Substrat 10 aufgebaut. Auf das gemeinsame Substrat 10 ist ein Resonatorspiegel 11 und eine gemeinsame Schichtstruktur 12, die optisch aktiv ist, aufgebracht. Die gemeinsame Schichtstruktur 12 stellt im Bereich der Halbleiterlaservorrichtung 1a einen Verstärkerbereich 12a, im Bereich des Detektorelements 1b eine strahlungsdetektierende Zone 12b und im Wellenleiterbereich 1c einen Wellenleiter 12c dar. Auf der gemeinsamen Schichtstruktur 12 ist ein Auskoppelspiegel 13 angeordnet, der teilweise von einer Deckschicht 14 abgedeckt ist. Nicht abgedeckte Bereiche weisen entweder ein Fenster 15 oder p-Kontakte 16 und 17 auf, wobei 16 der p-Kontakt der Halbleiterlaservorrichtung 1a und 17 der p-Kontakt des Detektorelements 1b ist. Auf der dem Resonatorspiegel 11 gegenüberliegenden Seite des Substrats 10 ist ein n-Kontakt 18 des optischen Sensormoduls 1 aufgebracht. Im Bereich der Halbleiterlaservorrichtung 1a ist der Auskoppelspiegel 13 in unmittelbarer Nähe zu dem p-Kontakt 16 der Halbleiterlaservorrichtung 1a durch Isolatoren 19 unterbrochen. Ein weiterer Isolator 19 befindet sich im Auskoppelspiegel 13 im Bereich des Detektorelements 1b. Weiterhin befindet sich in dem Auskoppelspiegel 13 im Bereich der Halbleiterlaservorrichtung 1a innerhalb der Isolatoren 19 eine Barriereschicht 20, die eine zentrale Öffnung aufweist. Zwischen dem p-Kontakt 16 der Halbleiterlaservorrichtung 1a und dem n-Kontakt 18 des optischen Sensormoduls 1 verlaufen schematisch angedeutete Strompfade 21.

Die im linken Teil des optischen Sensormoduls 1 angeordnete Halbleiterlaservorrichtung 1a ist als eine oberflächenemittierende Halbleiterlaserdiode (VCSEL - vertical cavity surface emitting laser) ausgeführt. Ein möglicher Aufbau einer solchen VCSEL-Struktur ist, den Verstärkerbereich 12a als einzelnen Quantentopf (SQW - single quantum well) oder als eine Schichtabfolge von Quantentöpfen (MQW - multiple quantum wells) auszuführen und beidseitig von Bragg-Spiegeln zu umgeben, die als Auskoppelspiegel 13 beziehungsweise als Resonatorspiegel 11 fungieren. Der Verstärkerbereich 12a kann dabei zum Beispiel Quantentopfstrukturen aus InGaAs, eingebettet zwischen Barriereschichten aus GaAlAs aufweisen und die Bragg-Spiegel können aus einer Schichtabfolge von abwechselnd GaAs und AlAs bestehen. Wird ein n-dotiertes Material als Substrat 10 eingesetzt, sind ebenfalls n-dotierte Materialien für den Resonatorspiegel 11 vorgesehen, wohingegen der Auskoppelspiegel 13 aus p-dotiertem Material besteht. Durch den beschriebenen Schichtaufbau wird ein senkrecht zum Substrat liegender optischer Resonator um den Verstärkerbereich 12a gebildet. Elektrisch stellt die beschriebene Schichtanordnung zusammen mit dem p-Kontakt 16 der Halbleiterlaservorrichtung 1a sowie dem n-Kontakt 18 des optischen Sensormoduls 1 eine Diode dar, bei der, in Durchflussrichtung betrieben, Ladungsträger in den Verstärkerbereich 12a injiziert werden. Die Anordnung und Größe des p-Kontakts 16 sowie der Isolatoren 19 und der Barriereschicht 20 bedingt dabei eine Stromkonzentration in einem eingeschränkten Bereich des Verstärkerbereichs 12a mit einhergehender hoher Stromdichte und großer Besetzungsinversion. Die Isolatoren 19 und die Barriereschicht 20 können z.B. durch eine Ionenimplantation oder durch lokales Abätzen und Oxidieren erstellt werden.

In dem im Folgenden als gepumpt bezeichneten Bereich hoher Besetzungsinversion im Verstärkerbereich 12a entsteht durch resonante Verstärkung entlang der Resonator-Achse innerhalb des Resonators ein kohärentes Strahlungsfeld. Ein Teil dieses Strahlungsfeldes verlässt als kohärente Strahlung 3 die Halbleiterlaseranordnung 1a durch das an entsprechender Stelle angeordnete Fenster 15.

Neben der kohärenten Strahlung 3 geht von dem gepumpten Bereich des Verstärkerbereichs 12a die teilweise inkohärente Strahlung 5 aus. Ein Teil dieser Strahlung wird unter einem solchen Winkel relativ zur Ebene des Verstärkerbereichs 12a emittiert, dass er an den Grenzflächen des Verstärkerbereichs 12a zum Resonatorspiegel 11 beziehungsweise zum Auskoppelspiegel 13 mittels Reflexion geführt wird. Dieser Teil wird somit entlang der gemeinsamen Schichtstruktur 12 geleitet. Auch diese Strahlung kann auf ihrem Weg innerhalb des gepumpten Bereichs des Verstärkerbereichs 12a unter Umständen durch induzierte Emission verstärkt werden. Diese ist jedoch nicht resonant, weswegen die resultierende Strahlung ein breiteres Spektrum und eine kleinere Kohärenzlänge aufweist als die resonant verstärkte kohärente Strahlung 3. Zu einem kleineren Teil rührt die teilweise inkohärente Strahlung 5 von Streuung des Strahlungsfeldes im Resonator an Defekten des Verstärkerbereichs 12a her.

Da im gezeigten Ausführungsbeispiel die optisch aktive gemeinsame Schichtstruktur 12 über das gesamte optische Sensormodul 1 die gleiche epitaktische Struktur aufweist, wird die teilweise inkohärente Strahlung 5 näherungsweise verlustfrei an Grenzschichten von der Halbleiterlaservorrichtung 1a in den Bereich des Detektorelements 1b geleitet, wobei die gemeinsame Schichtstruktur 12 im dazwischen liegende Wellenleiterbereich 1c als Wellenleiter 12c fungiert. Durch die Isolatoren 19 und die Anordnung der p-Kontakte 16 und 17 ist der Wellenleiterbereich 1c weitgehend frei von elektrischen Feldern.

Gegenüber dem Wellenleiterbereich 1c unterscheidet sich das angrenzende Detektorelement 1b bei ansonsten gleichem epitaktischen Schichtaufbau durch den auf den Auskoppelspiegel 13 aufgebrachten p-Kontakt 17. Wie auch die Halbleiterlaservorrichtung 1a stellt das Detektorelement 1b elektrisch eine Diode dar, die im Betrieb allerdings in Sperrrichtung gepolt benutzt wird. Das dadurch aufgebaute elektrische Feld führt zu einer Trennung von Ladungsträgern, die bei der Absorption der teilweise inkohärenten Strahlung 5 in der gemeinsamen Schichtstruktur 12 entstehen. Die Ladungsträgertrennung resultiert in einem Stromsignal, das im wesentlichen proportional zur Intensität der teilweise inkohärenten Strahlung 5 ist und zur Bestimmung ihrer Intensität herangezogen werden kann. Im Bereich des Detektorelements 1b wirkt die gemeinsame Schichtstruktur 12 folglich als strahlungsdetektierende Zone 12b. Der gleiche Schichtaufbau von Verstärkerbereich 12a und strahlungsdetektierender Zone 12b führt zu der vorteilhaften Situation, dass in der strahlungsdetektierenden Zone 12b gerade Strahlung derjenigen Wellenlänge besonders gut absorbiert wird, die in dem Verstärkerbereich 12a bevorzugt als spontan emittierte Strahlung ausgesandt wird.

Die Intensität der kohärenten Strahlung 3 und auch der teilweise inkohärenten Strahlung 5 sind in eindeutiger Weise von der Größe der Besetzungsinversion im gepumpten Bereich des Verstärkerbereichs 12a abhängig. Das Stromsignal des Detektorelements 1b ist daher ein Maß für die Intensität der Strahlung im Resonator und auch der Intensität der kohärenten Strahlung 3. Damit stellt das Detektorelement 1c einen vielseitig einsetzbaren, integrierten Intensitätsmonitor für die Halbleiterlaservorrichtung 1a dar. Vorteilhaft an dem gezeigten Ausführungsbeispiel ist, dass das gesamte optische Sensormodul 1 im wesentlichen über den gleichen epitaktischen Schichtaufbau verfügt, was einen kompakten Aufbau und die Vereinfachung des Herstellungsprozesses ermöglicht. Weiterhin zeichnet sich das optische Sensormodul 1 durch eine besonders geringe Empfindlichkeit für Umgebungslicht aus, da das Detektorelement 1b nicht auf der optischen Achse des Resonators der Halbleiterlaservorrichtung 1a liegt.

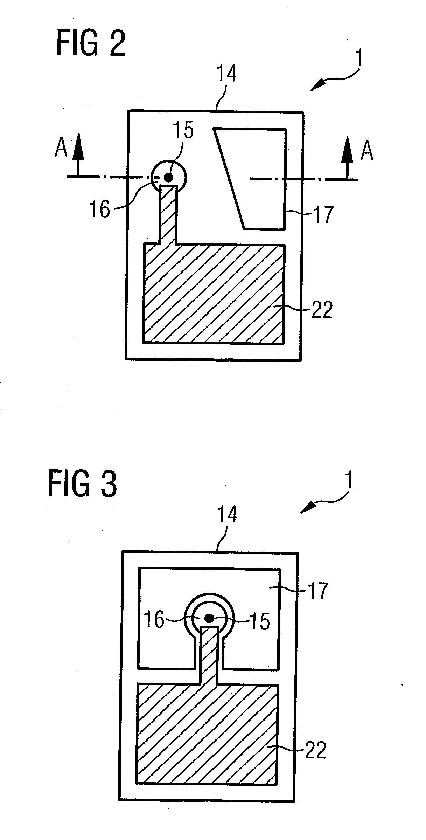

In Figur 2 ist eine Aufsicht auf das Ausführungsbeispiel des optischen Sensormoduls 1 gemäß Figur 1 gezeigt. Der in Figur 1 dargestellte Schnitt wird durch die Linie A-A angegeben.

In dieser Darstellung ist zu erkennen, dass der p-Kontakt 16 der Halbleiterlaservorrichtung 1a ringförmig um das ebenfalls runde Fenster 15 ausgeführt ist. Auf diese Weise wird eine möglichst radialsymmetrisches Strahlprofil der abgestrahlten kohärenten Strahlung 3 erreicht. Der Durchmesser des p-Kontakts 16 ist der Anordnung der Isolatoren 19 angepasst. Er übersteigt den Durchmesser des Fensters 15 nur wenig, um eine hohe Stromdichte im gepumpten Bereich der Halbleiterlaservorrichtung zu gewährleisten. Da die Größe des p-Kontakts 16 für einen externen elektrischen Anschluss nicht ausreicht, wird auf die Deckschicht 14 eine mit dem p-Kontakts 16 verbundene Kontaktfläche 22, z.B. in Form einer metallischen Anschlussfläche, aufgebracht.

Der p-Kontakt 17 des Detektorelements 1b ist dagegen möglichst großflächig ausgeführt. Seine Größe bestimmt die Größe der strahlungsdetektierenden Zone 12b und somit die Detektionsempfindlichkeit. Die Abmessungen des p-Kontakts 17 sind im gezeigten Ausführungsbeispiel ausreichend für einen elektrischen Anschluss, so dass hier auf eine zusätzliches Anschlussfläche verzichtet werden kann.

In Figur 3 ist in analoger Darstellung eine Aufsicht auf ein weiteres Ausführungsbeispiel des optischen Sensormoduls 1 gezeigt.

Bei diesem Ausführungsbeispiel ist die Halbleiterlaservorrichtung 1a in seitlicher Richtung mittig im optischen Sensormodul 1 angeordnet. Ansonsten sind der p-Kontakt 16, das Fenster 15 und die Kontaktfläche 22 wie bei dem in Figur 2 gezeigten Beispiel ausgeführt. Die mittige Anordnung erlaubt, den p-Kontakt 17 des Detektorelements 1b so auszuführen, dass er den p-Kontakt 16 abgesehen von einer Aussparung um den stegförmigen Teil der Kontaktfläche 22 fast vollständig umgibt. Entsprechend ist in dem optischen Sensormodul 1 der Verstärkerbereichs 12a nahezu radialsymmetrisch von der strahlungsdetektierende Zone 12b und dem dazwischenliegenden Wellenleiter 12c umgeben, wodurch die Detektionsempfindlichkeit maximiert wird.

Über die nachfolgend beschriebene Verwendung des optischen Sensormoduls 1 zur Bestimmung der Geschwindigkeit eines bewegten Objekts 2 hinaus ist ein Einsatz denkbar, bei dem das Detektorelement 1b zur Intensitätsregulierung oder Kontrolle der abgestrahlten kohärenten Strahlung 3 eingesetzt wird.

Bei einer Verwendung des optischen Sensormoduls 1 zur Bestimmung der Bewegung eines von der kohärenten Strahlung 3 beleuchteten Objekts 2 wird ausgenutzt, dass ein Teil der von dem Objekt 2 zurückgestreuten Strahlung 4 durch das Fenster 15 wieder in den Resonator der Halbleiterlaservorrichtung 1a eindringt. Die rückgestreute Strahlung 4 interferiert mit dem Strahlungsfeld im Resonator falls der doppelte Abstand zwischen Sensormodul 1 und Objekt 2 kleiner ist als die Kohärenzlänge des kohärenten Lichts 3. Die Interferenz führt zu einer Änderung der Intensität des Strahlungsfelds im Resonator, die abhängig von der Phasenlage der rückgestreuten Strahlung 4 und somit vom Abstand zwischen dem Sensormodul 1 und dem Objekt 2 ist. Bei Bewegung des Objekts 2 relativ zum optischen Sensormodul 1 ist diese Intensität des Strahlungsfelds im Resonator nicht konstant sondern entsprechend moduliert. Aufgrund des eindeutigen Zusammenhangs zwischen der Intensität des Strahlungsfeldes im Resonator und des Stromsignals des Detektorelements 1b ist das Stromsignal des Detektorelements 1b bei Bewegung des Objekts 2 ebenfalls moduliert. Diese Modulation wird ausgewertet. Ihre Frequenz ist proportional zur Geschwindigkeit der Bewegung des Objekts 2.

Die direkte Detektion der Frequenz der Modulation wird vereinfacht, wenn die gemittelte Intensität des kohärenten Lichts der Halbleiterlaservorrichtung 1a möglichst konstant gehalten wird. In vorteilhafter Weise kann dieses ebenfalls über das Stromsignal des Detektorelements 1b geschehen, in dem ein niederfrequenter Anteil des Stromsignals des Detektorelements zur Intensitätskontrolle herangezogen wird und ein höherfrequenter Anteil zur Bestimmung des Bewegungszustands des Objekts ausgewertet wird.

Alternativ zu einer direkten Bestimmung der Frequenz der Modulation ist möglich, die Halbleiterlaservorrichtung 1a so zu betreiben, dass die von ihr abgestrahlte kohärente Strahlung 3 bereits moduliert ist. Das Stromsignal des Detektorelements 1b gibt diese Modulation im wesentlichen wieder, allerdings mit einer von der ursprünglichen Modulation abweichenden Signalform. Die Abweichung wird durch die zusätzliche Modulation durch die Bewegung des Objekts 2 hervorgerufen. Aus der Abweichung der Signalform kann folglich die Bewegung des Objekts 2 bestimmt werden. Eine geeignete Signalform zur Modulation der abgestrahlten Intensität stellt ein Sägezahn dar.

Auch eine Bewegung des Objekts 2, die nicht entlang der Strahlrichtung der kohärenten Strahlung 3 erfolgt, kann mit diesem Verfahren bestimmt werden. Es ist in diesem Fall nur die Projektion der Bewegung auf die Hauptstrahlungsrichtung relevant.

Auch die Bestimmung der Bewegung einer Ebene parallel und relativ zu dem optischen Sensormodul 1 ist möglich. Ein Einsatzgebiet für diese Anwendung stellen zum Beispiel die sogenannten berührungslosen optischen Computermäuse dar. Hier sind zwei optischen Sensormodulen 1 vorgesehen, die zueinander so angeordnet sind, dass die jeweilige Strahlungsrichtung der kohärenten Strahlung 3 einen Winkel größer null Grad zur Ebenennormale bildet und ihre Projektion auf die Ebene zueinander einen Winkel größer null Grad, vorteilhafterweise 90 Grad, bildet.

## Patentansprüche

1. Optisches Sensormodul (1) mit einem Halbleiterkörper auf einem gemeinsamen Substrat (10), der umfasst:
- eine gemeinsame Schichtstruktur (12),
- einen Resonatorspiegel (11) zwischen dem Substrat (10) und der Schichtstruktur (12),
- einen Auskoppelspiegel (13) an einer dem Substrat (10) abgewandten Seite der Schichtstruktur (12),
- eine oberflächenemittierende Halbleiterlaservorrichtung (1a) zur Emission von kohärenter Strahlung (3) mit einem Verstärkerbereich (12a),
- ein Detektorelement (1b) mit einer strahlungsdetektierenden Zone (12b),
- einen Wellenleiterbereich (1c) mit einem Wellenleiter (12c), und
- elektrische Isolatoren (19),
wobei
- die Halbleiterlaservorrichtung (1a), das Detektorelement (1b) und der Wellenleiterbereich (1c) monolithisch integriert sind,
- der Wellenleiter (12c) in einer Richtung quer zur Hauptstrahlungsrichtung der von der Halbleiterlaservorrichtung (1a) emittierten kohärenten Strahlung (3) angeordnet ist, und
- das Detektorelement (1b) über den Wellenleiter (12c) mit der Halbleiterlaservorrichtung (1a) verbunden ist,
wobei
- die gemeinsame Schichtstruktur (12) für die Halbleiterlaservorrichtung (1a) den Verstärkerbereich (12a), für das Detektorelement (1b) die strahlungsdetektierende Zone (12b) und für den Wellenleiterbereich (1c) den Wellenleiter (12c) bildet, und
- die Schichtstruktur (12) in der Halbleiterlaservorrichtung (1a), dem Detektorelement (1b) und dem Wellenleiterbereich (1c) die gleiche epitaktische Schichtanordnung aufweist,
**dadurch gekennzeichnet, dass**
durch die elektrischen Isolatoren (19) nur Auskoppelspiegel (13) die Stromleitung quer zur Hauptstrahlungsrichtung unterbrochen ist und sich die Schichtstruktur (12) über das gesamte optische Sensormodul (1) erstreckt.

2. Optisches Sensormodul (1) nach Anspruch 1, **dadurch gekennzeichnet, dass**
der Wellenleiter (12c) in einer Richtung senkrecht zur Hauptstrahlungsrichtung der von der Halbleiterlaservorrichtung (1a) emittierten kohärenten Strahlung (3) angeordnet ist.

3. Optisches Sensormodul (1) nach einem der Ansprüche 1 oder 2, **dadurch gekennzeichnet, dass**
das Detektorelement (1b) zur Detektion von Strahlung aus der Halbleiterlaservorrichtung (1a) eingerichtet ist.

4. Optisches Sensormodul (1) nach einem der Ansprüche 1 bis 3, **dadurch gekennzeichnet, dass**
die von dem Detektorelement (1b) detektierte Strahlung aus der Halbleiterlaservorrichtung (1a) teilweise inkohärente Strahlung (4) ist.

5. Optisches Sensormodul (1) nach einem der Ansprüche 1 bis 4, **dadurch gekennzeichnet, dass**
die gemeinsame Schichtstruktur (12) mindestens eine Quantentopfstruktur enthält.

6. Optisches Sensormodul (1) nach einem der Ansprüche 1 bis 5, **dadurch gekennzeichnet, dass**
sich an einer dem Substrat (10) abgewandten Seite des Auskoppelspiegels (13) ein p-Kontakt (16) der Halbleiterlaservorrichtung (1a) befindet, der ein Fenster (15) für von dem Halbleiterlaserelement (1a) erzeugtes Licht ringsum umgibt,
wobei im Bereich der Halbleiterlaservorrichtung (1a) der Auskoppelspiegel (13) in unmittelbarer Nähe zu dem p-Kontakt (16) von den Isolatoren (19) ringsum unterbrochen ist.

7. Optisches Sensormodul (1) nach einem der Ansprüche 1 bis 6, **dadurch gekennzeichnet, dass**
der Resonatorspiegel (11) und der Auskoppelspiegel (13) Bragg-Spiegel sind.

8. Verwendung eines optischen Sensormoduls nach einem der Ansprüche 1 bis 7 zur Messung der Bewegung eines relativ zum Sensormodul bewegten und mit der von der Halbleiterlaservorrichtung (1a) emittierten kohärenten Strahlung (3) beleuchteten und rückstreuenden Objekts (2).

9. Verfahren zur Messung der Relativbewegung eines Objekts (2) gegenüber einem optischen Sensormodul (1) nach einem der Ansprüche 1 bis 7, bei dem
- das Objekt (2) mit der von der Halbleiterlaservorrichtung (1a) emittierten kohärenten Strahlung (3) beleuchtet wird,
- ein Teil der von dem Objekt (2) zurückgestreuten Strahlung (4) mit der Strahlung innerhalb der Halbleiterlaservorrichtung (1a) derart überlagert wird, dass die Intensität der von der Halbleiterlaservorrichtung (1a) erzeugten teilweise inkohärenten Strahlung (5) von der zurückgestreuten Strahlung (4) abhängig ist,
- die Intensität der teilweise inkohärenten Strahlung (5) von dem Detektorelement (1b) gemessen wird und
- anhand des Signals des Detektorelements (1b) die Bewegung des Objekts (2) relativ zur Richtung der von der Halbleiterlaservorrichtung (1a) emittierten kohärenten Strahlung (3) bestimmt wird.

10. Verfahren nach Anspruch 9, **dadurch gekennzeichnet, dass** die Überlagerung der zurückgestreuten Strahlung (4) mit der Strahlung innerhalb der Halbleiterlaservorrichtung (1a) zu einer Änderung der Größe der Besetzungsinversion in der Halbleiterlaservorrichtung (1a) führt.

11. Verfahren nach Anspruch 10, **dadurch gekennzeichnet, dass** die Änderung der Größe der Besetzungsinversion zu einer Änderung der Intensität der von der Halbleiterlaservorrichtung (1a) emittierten, teilweise inkohärenten Strahlung (5) führt.

12. Verfahren nach einem der Ansprüche 9 bis 11, **dadurch gekennzeichnet, dass**
die teilweise inkohärente Strahlung (5) der Halbleiterlaservorrichtung (1a) über den Wellenleiter (12c) in das Detektorelement (1b) geführt wird.

## Claims

1. Optical sensor module (1) comprising a semiconductor body on a common substrate (10), said semiconductor body comprising:
- a common layer structure (12),
- a resonator mirror (11) between the substrate (10) and the layer structure (12),
- a coupling-out mirror (13) at a side of the layer structure (12) which is remote from the substrate (10),
- a surface emitting semiconductor laser device (1a) for the emission of coherent radiation (3) with an amplifier region (12a),
- a detector element (1b) with a radiation-detecting zone (12b),
- a waveguide region (1c) with a waveguide (12c), and
- electrical insulators (19),
wherein
- the semiconductor laser device (1a), the detector element (1b) and the waveguide region (1c) are monolithically integrated,
- the waveguide (12c) is arranged in a direction transversally with respect to the main radiation direction of the coherent radiation (3) emitted by the semiconductor laser device (1a), and
- the detector element (1b) is connected to the semiconductor laser device (1a) via the waveguide (12c),
whererin
- the common layer structure (12) forms the amplifier region (12a) for the semiconductor laser device (1a) , the radiation-detecting zone (12b) for the detector element (1b) and the waveguide (12c) for the waveguide region (1c), and
- the layer structure (12) has the same epitaxial layer arrangement in the semiconductor laser device (1a), the detector element (1b) and the waveguide region (1c),
**characterized in that**
the current conduction transversely with respect to the main radiation direction is interrupted by the electrical insulators (19) only in the coupling-out mirror (13) and the layer structure (12) extends over the entire optical sensor module (1).

2. Optical sensor module (1) according to Claim 1, **characterized in that**
the waveguide (12c) is arranged in a direction perpendicular to the main radiation direction of the coherent radiation (3) emitted by the semiconductor laser device (1a).

3. Optical sensor module (1) according to either of Claims 1 and 2, **characterized in that**
the detector element (1b) is designed for the detection of radiation from the semiconductor laser device (1a).

4. Optical sensor module (1) according to any of Claims 1 to 3, **characterized in that**
the radiation from the semiconductor laser device (1a) that is detected by the detector element (1b) is partly incoherent radiation (4).

5. Optical sensor module (1) according to any of Claims 1 to 4, **characterized in that**
the common layer structure (12) contains at least one quantum well structure.

6. Optical sensor module (1) according to any of Claims 1 to 5, **characterized in that**
a p-type contact (16) of the semiconductor laser device (1a) is situated at a side of the coupling-out mirror (13) which is remote from the substrate (10), said contact surrounding all around a window (15) for light generated by the semiconductor laser element (1a),
wherein, in the region of the semiconductor laser device (1a), the coupling-out mirror (13) in direct proximity to the p-type contact (16) is interrupted all around by the insulators (19).

7. Optical sensor module (1) according to any of Claims 1 to 6, **characterized in that**
the resonator mirror (11) and the coupling-out mirror (13) are Bragg mirrors.

8. Use of an optical sensor module according to any of Claims 1 to 7 for measuring the movement of a backscattering object (2) which is moved relative to the sensor module and is illuminated with the coherent radiation (3) emitted by the semiconductor laser device (1a) .

9. Method for measuring the relative movement of an object (2) with respect to an optical sensor module (1) according to any of Claims 1 to 7, wherein
- the object (2) is illuminated with the coherent radiation (3) emitted by the semiconductor laser device (1a),
- part of the radiation (4) backscattered by the object (2) is superimposed with the radiation within the semiconductor laser device (1a) in such a way that the intensity of the partly incoherent radiation (5) generated by the semiconductor laser device (1a) is dependent on the backscattered radiation (4),
- the intensity of the partly incoherent radiation (5) is measured by the detector element (1b), and
- the movement of the object (2) relative to the direction of the coherent radiation (3) emitted by the semiconductor laser device (1a) is determined on the basis of the signal of the detector element (1b).

10. Method according to Claim 9, **characterized in that** the superimposition of the backscattered radiation (4) with the radiation within the semiconductor laser device (1a) leads to a change in the magnitude of the population inversion in the semiconductor laser device (1a).

11. Method according to Claim 10, **characterized in that** the change in the magnitude of the population inversion leads to a change in the intensity of the partly incoherent radiation (5) emitted by the semiconductor laser device (1a).

12. Method according to any of Claims 9 to 11, **characterized in that**
the partly incoherent radiation (5) of the semiconductor laser device (1a) is guided via the waveguide (12c) into the detector element (1b).

## Revendications

1. Module de détection optique (1) doté d'un corps semi-conducteur sur un substrat (10) commun et qui comporte :
- une structure stratifiée (12) commune,
- un miroir de résonateur (11) disposé entre le substrat (10) et la structure stratifiée (12),
- un miroir de découplage (13) disposé sur le côté de la structure stratifiée (12) non tourné vers le substrat (10),
- un dispositif laser (1a) à semi-conducteur et émission de surface qui émet un rayonnement cohérent (3) et doté d'une partie d'amplification (12a),
- un élément de détection (1b) doté d'une zone (12b) de détection du rayonnement,
- une partie (1c) de guidage d'onde qui présente un guide d'onde (12c) et
- des isolateurs électriques (19),
- le dispositif laser (1a) à semi-conducteur, l'élément de détection (1b) et la partie (1c) de guidage d'onde étant intégrés monolithiquement,
- le guide d'onde (12c) étant disposé dans une direction transversale par rapport à la direction principale d'émission du rayonnement cohérent (3) émis par le dispositif laser (1a) à semi-conducteur et
- l'élément de détection (1b) étant relié par le guide d'onde (12c) au dispositif laser (1a) à semi-conducteur,
- la structure stratifiée (12) commune formant la partie d'amplification (12a) du dispositif laser (1a) à semi-conducteur, la zone (12b) de détection du rayonnement de l'élément de détection (1b) et le guide d'onde (12c) de la partie (1c) de guidage d'onde,
- la structure stratifiée (12) présentant la même disposition épitaxique de couches dans le dispositif laser (1a) à semi-conducteur, l'élément de détection (1b) et la partie (1c) de guidage d'onde,
**caractérisé en ce que**
seul le guidage du courant transversalement à la direction principale de rayonnement dans le miroir de découplage (13) est interrompu par les isolateurs électriques (19) et
**en ce que** la structure stratifiée (12) s'étend sur tout le module optique de détection (1).

2. Module de détection optique (1) selon la revendication 1, **caractérisé en ce que** le guide d'onde (12c) est disposé dans une direction perpendiculaire à la direction d'émission principale du rayonnement cohérent (3) émis par le dispositif laser (1a) à semi-conducteur.

3. Module de détection optique (1) selon l'une des revendications 1 ou 2, **caractérisé en ce que** l'élément de détection (1b) est conçu pour détecter le rayonnement émis par le dispositif laser (1a) à semi-conducteur.

4. Module de détection optique (1) selon l'une des revendications 1 à 3, **caractérisé en ce que** le rayonnement émis par le dispositif laser (1a) à semi-conducteur et détecté par l'élément de détection (1b) est un rayonnement (4) partiellement non cohérent.

5. Module de détection optique (1) selon l'une des revendications 1 à 4, **caractérisé en ce que** la structure stratifiée (12) commune contient au moins une structure formant un puits quantique.

6. Module de détection optique (1) selon l'une des revendications 1 à 5, **caractérisé en ce qu'**un contact p (16) du laser (1a) à semi-conducteur, qui entoure une fenêtre (15) prévue pour la lumière produite par l'élément laser (1a) à semi-conducteur, est situé sur le côté du miroir de découplage (13) non tourné vers le substrat (10), le miroir de découplage (13) étant interrompu périphériquement par les isolateurs (19) à proximité immédiate du contact p (16) dans la zone occupée par le dispositif laser (1a) à semi-conducteur.

7. Module de détection optique (1) selon l'une des revendications 1 à 6, **caractérisé en ce que** le miroir (11) de résonateur et le miroir de découplage (13) sont des miroirs de Bragg.

8. Utilisation d'un module de détection optique selon l'une des revendications 1 à 7 pour la mesure du déplacement d'un objet (2) qui se déplace par rapport au module de détection, qui est éclairé par le rayonnement cohérent (3) émis par le dispositif laser (1a) à semi-conducteur et qui le réfléchit de manière diffuse.

9. Procédé de mesure du déplacement relatif d'un objet (2) par rapport à un module de détection optique (1) selon l'une des revendications 1 à 7, dans lequel
- l'objet (2) est éclairé par le rayonnement cohérent (3) émis par le dispositif laser (1a) à semi-conducteur,
- une partie du rayonnement (4) réfléchi de manière diffuse par l'objet (2) est superposée au rayonnement à l'intérieur du dispositif laser (1a) à semi-conducteur de telle sorte que l'intensité du rayonnement partiellement non cohérent (5) produit par le dispositif laser (1a) à semi-conducteur dépend du rayonnement (4) renvoyé de manière diffuse,
- l'intensité du rayonnement partiellement non cohérent (5) est mesurée par l'élément de détection (1b) et
- le déplacement de l'objet (2) par rapport à la direction du rayonnement cohérent (3) émis par le dispositif laser (1a) à semi-conducteur est déterminé à l'aide du signal de l'élément de détection (1b).

10. Procédé selon la revendication 9, **caractérisé en ce que** la superposition du rayonnement (4) réfléchi de manière diffuse et du rayonnement à l'intérieur du dispositif laser (1a) à semi-conducteur entraîne une modification du niveau de l'inversion d'occupation dans le dispositif laser (1a) à semi-conducteur.

11. Procédé selon la revendication 10, **caractérisé en ce que** la modification du niveau de l'inversion de l'occupation entraîne une modification de l'intensité du rayonnement partiellement non cohérent (5) émis par le dispositif laser (1a) à semi-conducteur.

12. Procédé selon l'une des revendications 9 à 11, **caractérisé en ce que** le rayonnement partiellement non cohérent (5) du dispositif laser (1a) à semi-conducteur est amené dans l'élément de détection (1b) par l'intermédiaire du guide d'onde (12c).
